(19) Europäisches Patentamt / European Patent Office / Office européen des brevets

(11) **EP 3 574 331 B1**

(12) **EUROPEAN PATENT SPECIFICATION**

(45) Date of publication and mention
of the grant of the patent:
**14.10.2020 Bulletin 2020/42**

(21) Application number: **18702575.4**

(22) Date of filing: **25.01.2018**

(51) Int Cl.:
*G01R 27/28* (2006.01)     *G01R 35/00* (2006.01)
*G01R 31/28* (2006.01)

(86) International application number:
**PCT/NL2018/050055**

(87) International publication number:
**WO 2018/139926 (02.08.2018 Gazette 2018/31)**

(54) **AN INTERFEROMETRIC IQ-MIXER/DAC SOLUTION FOR ACTIVE, HIGH SPEED VECTOR NETWORK ANALYSER IMPEDANCE RENORMALIZATION**

INTERFEROMETRISCHE IQ-MIXER/DAC-LÖSUNG ZUR AKTIVEN, HOCHSCHNELLEN IMPEDANZRENORMIERUNG MITHILFE EINES VEKTORNETZWERKANALYSATORS

SOLUTION DE MÉLANGEUR IQ INTERFÉROMÉTRIQUE/CNA DE RENORMALISATION ACTIVE D'IMPÉDANCE D'ANALYSEUR DE RÉSEAU VECTORIEL À VITESSE ÉLEVÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.01.2017 NL 2018225**

(43) Date of publication of application:
**04.12.2019 Bulletin 2019/49**

(73) Proprietor: **Vertigo Technologies B.V.**
**2628 CD Delft (NL)**

(72) Inventors:
• **SPIRITO, Marco**
**2497 VN Den Haag (NL)**
• **GALATRO, Luca**
**2600 AA Delft (NL)**
• **ROMANO, Raffaele**
**2600 AA Delft (NL)**
• **MUBARAK, Faisal Ali**
**2600 AA Delft (NL)**

(74) Representative: **Nederlandsch Octrooibureau**
**P.O. Box 29720**
**2502 LS The Hague (NL)**

(56) References cited:
• **MUBARAK FAISAL ET AL: "Evaluation and modeling of measurement resolution of a vector network analyzer for extreme impedance measurements", 2015 86TH ARFTG MICROWAVE MEASUREMENT CONFERENCE, IEEE, 3 December 2015 (2015-12-03), pages 1-3, XP032849340, DOI: 10.1109/ARFTG.2015.7381475**
• **Gerasimos Vlachogimmakis ET AL: "An I/Q-Mixer-Steering Interferometric Technique for High- Sensitivity Measurement of Extreme Impedances", , 17 May 2015 (2015-05-17), XP055397231, Retrieved from the Internet: URL:http://ieeexplore.ieee.org/ielx7/71557 22/7166703/07166830.pdf?tp=&arnumber=71668 30&isnumber=7166703 [retrieved on 2017-08-09] cited in the application**
• **KAMEL HADDADI ET AL: "Interferometric technique for microwave measurement of high impedances", MICROWAVE SYMPOSIUM DIGEST (MTT), 2012 IEEE MTT-S INTERNATIONAL, IEEE, 17 June 2012 (2012-06-17), pages 1-3, XP032217070, DOI: 10.1109/MWSYM.2012.6259554 ISBN: 978-1-4673-1085-7**

**Description**

**Field of the invention**

The present invention relates to an interface device for connecting a vector network analyser to a device under test (DUT), and in a further aspect to a system for executing measurements on a device under test comprising a vector network analyser, and at least one DUT interface device according to an embodiment of the present invention. Furthermore, the present invention relates to a method for using such a system.

**Background art**

In the article by G. Vlachogiannakis et al., "An I/Q-Mixer-Steering Interferometric Technique for High-Sensitivity Measurement of Extreme Impedances", International Microwave Symposium, May 2015, a vectorial signal cancellation technique based on IQ phase steering is disclosed for measurements on a device under test using a vector network analyser (VNA). The disclosed system uses a splitter on the path of the $a_1$ signal, internally to the VNA. This implementation results in the fact that the signal driving the LO of the IQ mixer and the signal driving the DUT, propagate on different transmission lines, i.e., cables. This makes this setup very sensitive to relative phase fluctuation between the two signals, hampering the cancellation condition. Moreover, to feed back the signal inside the VNA after the splitter, allows to realize signal cancellation only for a subset of VNA's, namely the ones providing front jumpers. In the implementation disclosed in this article no synchronization between the VNA source and the DAC controlling the injection vector was realized, making frequency sweep slow since it is performed one frequency point at the time. Also, this prior art implementation used a resistive divider to create the injection signal, this solution provides no isolation between the main line and injection path, making the cancellation condition susceptible to mismatches along the lines causing reflected signals coupling on the other signal path (i.e., from main to injection path and vice versa). Furthermore, in this prior art implementation there is no capability of decoupling the power level of the main path from the one driving the IQ mixers (of passive type in the mentioned implementation) requiring a specific LO power level. This makes this prior art solution capable to operate only at fixed power level, modifying the power requires changes on the setup by means of mechanical attenuators. Finally, this prior art implementation does not consider active amplification after the IQ mixer, thus often using the mixer in the non-optimal (linear) region, since the amplitude of the injected vector is only defined by the IQ signals. Other examples of prior art can be seen in "Evaluation and modeling of measurement resolution of a vector network analyzer for extreme impedance measurements", 2015 86th ARFTG Microwave Measurement Conference, IEEE, 3 December 2015 by M. Faisal et al., and in "Interferometric technique for microwave measurement of high impedances",Microwave Symposium Digest, 2012 IEEE MTT-S International, IEEE, 17 June 2012 (2012-06-17), by K. Haddadi et al.

**Summary of the invention**

The present invention seeks to provide improved test set-up arrangements for high frequency measurements of (active) devices (device under test, DUT), which is less susceptible to distortions and more robust during operation, especially suited for devices having a high reflection coefficient ($\Gamma$) In present measurement systems and methods, such a high $\Gamma$ DUT will usually result in problems for performing accurate and repeatable measurements.

According to the present invention, a device under test (DUT) interface device is provided as described above, wherein the DUT interface device comprises an analyser terminal, a DUT terminal and a control input terminal, a divider/coupler component having a main terminal connected to the analyser terminal, a variable gain amplifier connected to a first branch terminal of the divider/coupler component, an I/Q mixer having an input terminal connected to an output terminal of the variable gain amplifier, a bridge/coupler component, of which first branch terminals are connected between a second branch terminal of the divider/coupler component and the DUT terminal for providing a test signal a to the DUT terminal, and second branch terminals are connected between an output of the I/Q mixer and a grounding impedance. This set-up allows the DUT interface device to be positioned directly adjacent the DUT, and as a result the components of the DUT interface device as well. This results in a much lower susceptibility to external distortions and hence better performance of actually testing a DUT, especially when the DUT has a high $\Gamma$ coefficient.

In a further aspect, the present invention relates to a system as defined above, wherein the DUT interface device is connected to an associated measuring port of the vector network analyser. The system further comprises a control unit connected to the vector network analyser and to control input terminals of associated ones of the at least one DUT interface device, wherein the control unit is arranged to provide quadrature control signals for the associated at least one DUT interface device. The at least one DUT interface device is connected directly to the device under test DUT. In a further aspect the (DC) quadrature control signals are generated by a digital to analogue converter and can vary synchronously to the frequency of the vector network analyser through a hardware trigger loop, allowing quasi real time frequency sweeps with signal cancellation.

In an even further aspect, the present invention relates to a method for using a system according to an embodiment of the present invention, wherein the system comprises a DUT interface device connected to a first measuring port of the vector network analyser. The method comprises calibrating the system by obtaining injection signal parameters and vector calibration coefficients to allow measurements of a device under test connected to the DUT interface device. The method comprises a calibration part wherein the proper injection signals for the DUT interface devices are determined, and optionally an actual measurement step, in which the proper injection signals are used, and which make the method especially suitable for a DUT having a high $\Gamma$ coefficient.

**Short description of drawings**

The present invention will be discussed in more detail below, with reference to the attached drawings, in which

Fig. 1 shows a schematic diagram of a prior art test set-up using an interferometric technique;
Fig. 2 shows a further prior art DUT set-up arrangement using an interferometric technique;
Fig. 3 shows a schematic diagram of an embodiment of a DUT interface device according to an embodiment of the present invention;
Fig. 4 shows a schematic diagram of a test set-up arrangement according to a further aspect of the present invention;
Fig. 5A-5C show flow charts of calibration/measurement method embodiment groups as used for the test set-up arrangement of Fig. 4;
Fig. 6 shows a flow chart for a test sequence using the test set-up arrangement of Fig. 4.

**Description of embodiments**

High frequency devices are characterized by their reflection ($\Gamma$) and transmission coefficients when driven from input and/or output, often represented in the S-parameter formalism when a vector correction is applied to the measurement instrument. Characterization of the device under test (DUT exhibiting a large voltage standing wave ratio (VSWR) condition, i.e.

$$(1+|\Gamma|)/(1-|\Gamma|) > 9,$$

(representing a $|\Gamma|=0.8$ and real impedances smaller than 5.5 $\Omega$ and larger than 450 $\Omega$),
result in an increased uncertainty of the measured impedance (i.e., Z), i.e., higher than two order of magnitude compared to the zero VSWR case. Thus, extreme impedances (i.e., falling under the VSWR>9 category), in respect to the system impedance (generally 50$\Omega$), present a big challenge for high frequency characterization.
The reason for this can be easily found observing the relation between the device impedance and the instrument measured parameter, i.e., $\Gamma$ vs. Z. For impedance levels between a few O's and a few hundredths Q's the derivative of the reflection coefficient versus impedance ($\delta \Gamma/\delta Z$) is high, resulting in a compression of the measured noise. When the impedance levels are shifted to the ones providing a VSWR larger than 9 the $\delta \Gamma/\delta Z$ derivate approaches zero, resulting in an expansion of the measured noise providing large uncertainty in DUT impedance value. E.g. the relative uncertainty of the measured impedance may increase more than two orders of magnitudes for impedance levels lower than 5.5$\Omega$ and higher than 450$\Omega$.
In order to provide low uncertainty measurements under high VSWR conditions, various techniques have been proposed to cancel the large reflecting wave scattered by the DUT during testing, i.e., transforming the device back to a low VSWR case. These techniques can be grouped based on the implemented method:

1) matching approaches (i.e., transforming the impedance using passive elements),
2) interferometric techniques, i.e., cancelling the reflected signal with a signal with similar amplitude and opposite phase.

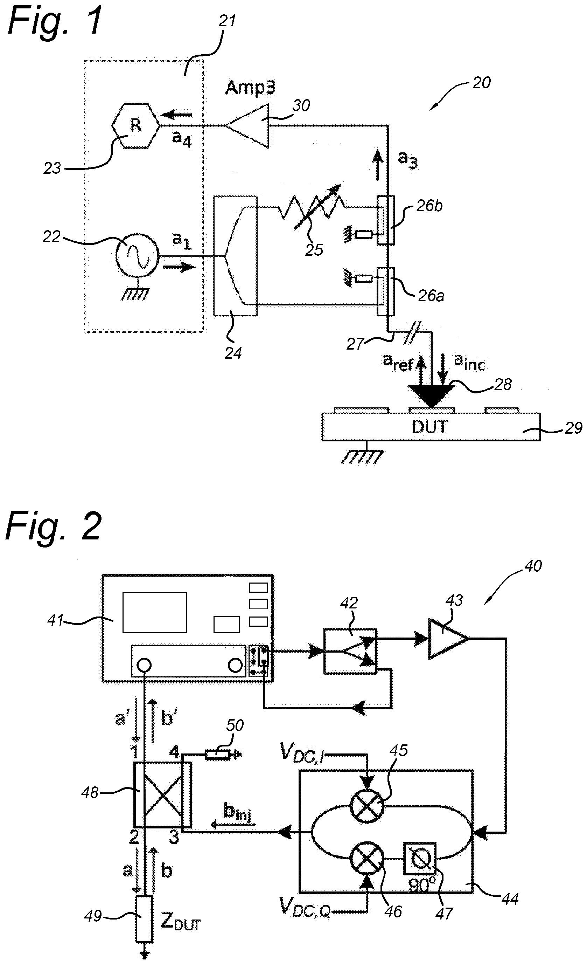

Several interferometric techniques to achieve impedance renormalization of a one-port VNA are known in the art. An exemplary test set-up using a network analyser 21 is shown in the schematic view of Fig. 1. The driving signal $a_1$ in Fig. 1 originating from oscillator 22 is first split in two equal-power branches using splitter 24. One of the splitter branches is used to drive the DUT 29 through a directional coupler 26a in order to provide an incoming signal $a_{inc}$ at the plane 28 of the DUT 29. The reflected signal $a_{refl}$ is then fed back via a (phase shifting) cable 27. The other branch of the splitter 24 is connected to a variable attenuator 25 and used as a cancellation signal using an upper directional coupler 26b. The cancellation signal is combined with the reflected signal $a_{ref}$ from the DUT 29 creating the (low level)

signal $a_3$. This signal $a_3$ is amplified using amplifier 30 and input as measurement signal $a_4$ to a receiver input 23 of the network analyser 21.

The large electrical distance between the injection point of the cancellation signal (at the upper directional coupler 26b) and the DUT 29 (i.e., due to cables 27 and two directional couplers 26a, 26b) makes the cancellation condition extremely sensitive to system variations (i.e., phase and amplitude due to cable 27 movements and temperature fluctuations). Moreover the use of only a variable attenuator 25 makes the cancellation condition possible only at specific frequencies i.e., frequencies at which the phase of the injected signal is opposite to the phase of the reflected signal at the plane of $a_3$.

As mentioned above, in the article G. Vlachogiannakis, H.T. Shivamurthy, et al., "An I/Q-Mixer-Steering Interferometric Technique for High-Sensitivity Measurement of Extreme Impedances", International Microwave Symposium, May 2015, an interferometric (cancellation) technique based on IQ phase steering is disclosed. Fig. 2 shows a schematic diagram of a test set-up 40 using this interferometric technique. The system uses a splitter 42 on the path of the $a_1$ signal (i.e. the generated test signal), external to the (vector) network analyser, VNA, 41. In Fig. 2 the splitter 42 is shown as being implemented external to the VNA 41, requiring suitable front terminals (jumpers) on the VNA 41 to allow feedback of the (split) signal to the VNA 41. The other part of the (split) signal from splitter 42 is fed to an amplifier 43 as an input to an IQ mixer 44. Under control of two control voltages $V_{DC,I}$ and $V_{DC,Q}$ and two mixers 45, 46 and a phase shifter 47 as internal components of the IQ mixer 44, an injection signal $b_{inj}$ is provided to a coupler 48. The other ports of the coupler 48 are connected to the VNA 41 port (receiving the $a'$ signal), a terminating impedance 50, and the DUT 49 (depicted as impedance $Z_{DUT}$).

This implementation of the test set-up 40 results in the fact that the signal driving the LO of the IQ mixer 44 and the signal driving the DUT 49, propagate on different transmission lines, i.e., cables. This makes this setup very sensitive to relative phase fluctuation between the two signals, hampering the cancellation condition, since small variations on large vectors cause a large residual vector difference which corresponds to the b' wave in Fig. 2. Moreover, splitting the signal, and feeding back the signal inside the VNA 41, allows to realize impedance normalization only for a subset of VNAs, namely the ones providing front jumpers. The usage of a resistive splitter does not provide isolation arising from mismatches at the input port of PA 43, increasing the unwanted coupling between the signal driving the DUT 49 and the LO of the IQ mixer 44. Furthermore, the mentioned implementation does not provide the capability to vary the power driving the DUT 49 without modifying the setup, i.e., changing the attenuation/amplification to the IQ mixer 44, since the LO port of the mixer needs to be driven at the proper power level to optimize performance, (e.g. with respect to conversion losses). The amplitude of the cancellation vector is directly set from the $V_{DC,I}$ and $V_{DC,Q}$ signals, imposing a larger linearity from the IQ mixer and making the cancellation algorithm more sensitive due to amplitude to phase non-linearities arising from the mixer (AM to PM conversion). Finally, in the implementation of Fig. 2 no hardware synchronization between the VNA 41 source and the DAC controlling the injection vector $V_{DC,I}$ and $V_{DC,Q}$ was realized, making frequency sweep slow since it is performed one frequency at the time.

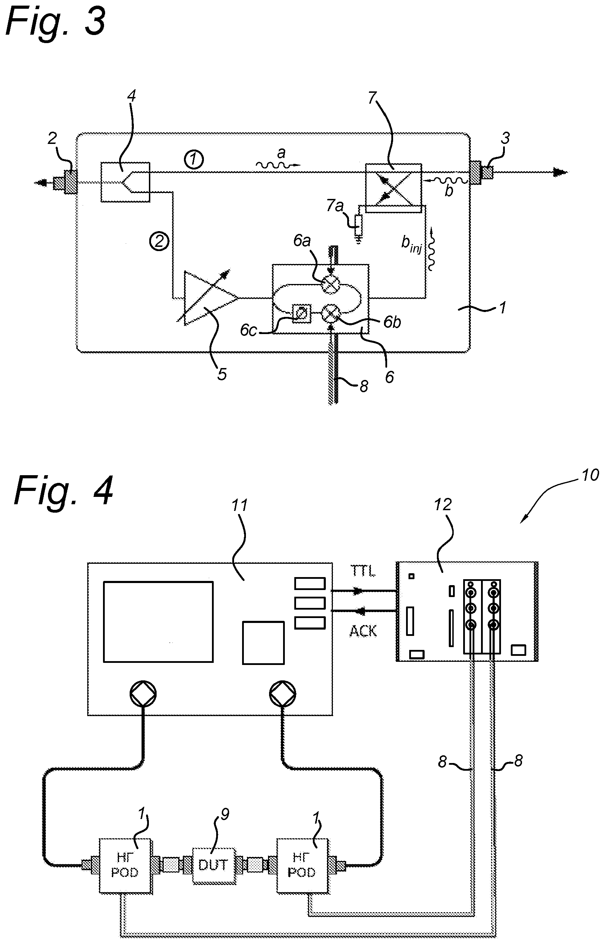

The present invention embodiments provide solutions to the disadvantages associated with prior art set-ups as discussed above. Fig. 3 shows a schematic diagram of a DUT interface device 1 (or High Gamma pod, HΓ-pod) according to an embodiment of the present invention, and Fig. 4 shows the system 10 set-up for executing test of a DUT 9 with a vector network analyser 11, in a two-port configuration. Each DUT interface device 1 is a two port device, allowing to realize a signal cancellation loop, and allowing its use with any commercially available multiport VNA 11.

In general, the present invention relates to a device under test (DUT) interface device 1 (or high gamma (HΓ)-pod) for connecting a vector network analyser 11 to a device under test 9. The DUT interface device 1 comprises an analyser terminal 2, a DUT terminal 3, and a control input terminal 8. A divider/coupler component 4 is present having a main terminal connected to the analyser terminal 2, a variable gain amplifier 5 is connected to a first branch terminal of the divider/coupler component 4, and an I/Q mixer 6 is present having an input terminal connected to an output terminal of the variable gain amplifier 5. Furthermore, a bridge/coupler component 7 is present, of which first branch terminals are connected between a second branch terminal of the divider/coupler component 4 and the DUT terminal 3 for providing a test signal a to the DUT terminal 3, and second branch terminals are connected between an output of the I/Q mixer 6 and a grounding impedance 7a. Such a DUT interface device 1 having all relevant elements for the intended purpose, allows a connection close to the DUT 9, and hence a better performance for measurements, as the relevant leads and connections are close to the DUT 9.

In a further embodiment, an additional power amplifier may be added receiving an output from the I/Q mixer 6, and providing an amplified signal to the bridge/coupler component 7. This allows to further optimize the I/Q linearity.

In an embodiment, the I/Q mixer 6 is arranged to generate an injection signal $b_{inj}$ which is coherently combined with a reflected signal b received on the DUT terminal 3. Again, as this takes place in the DUT interface device 1 close to the DUT, it will be less likely that errors or interference occurs. More in particular, the cancellation is close to the DUT 9 thus the sensitivity of the cancellation condition, due to vibration or changes in the setup is less pronounced. In an even further embodiment, the I/Q mixer 6 (and optionally the variable gain amplifier 5) is connected to the control input terminal 8. This allows to use proper wiring to run to the DUT interface device 1, which as a result will be less susceptible to distortion or other error introducing effects. Since all the loops are incorporated near the DUT 9, the LO and RF path are coupled, thus creating phase fluctuation (which in effect are the ones leading to the errors in the interferences) coherent which do ratio out in the cancellation condition.

In an even further embodiment, the variable gain amplifier 5 comprises a plurality of variable attenuators. The presence of the variable gain amplifier 5, possibly in the form of variable or switchable attenuators, allows to independently control power between the RF signal to the DUT 9 and the local oscillator signal in the I/Q mixer 6, which allows to optimize the drive level of the I/Q mixer 6 and at the same time providing independent power control towards the DUT 9 (via the signal generated from the analyser terminal 2). In an even further embodiment this is implemented using an integrated circuit digitally controlled variable attenuator, obviating any switching parts.

A simplified schematic view of the DUT interface device 1 (HΓ pod) according to a present invention embodiment is shown in Fig. 3. The DUT interface device 1 comprises two terminals 2, 3 and a control signal input 8, as a single, compact unit. In the DUT interface device 1, after the input terminal 2 a high directivity power divider/coupler 4 is placed to split the test signal a wave between two different paths (indicated by numerals 1 and 2 in circles). In other terms, the divider/coupler component (4) is a high directivity power divider/coupler splitting a test signal on the main terminal over the first and second branch terminal.

In the specific embodiment shown in Fig. 3, the signal at port 1 of the divider/coupler 4 serves as test signal a to stimulate the DUT 9 via output terminal 3. The signal at port 2 of the divider/coupler 4 is used to generate the phase coherent cancellation signal $b_{inj}$ required to cancel the scattered wave b originating from the DUT 9 during the execution of a test. The split signal part (or wave) at port 2 of the divider coupler 4 is first amplified, using a variable gain amplifier 5, to an adequate level (i.e., to toggle the switching core of the mixer) and is then used as the local oscillator (LO) signal of an IQ mixer 6. The IQ mixer 6 comprises internal components (mixers 6a, 6b and phase shifter 6c) which as such are known to the person skilled in the art.

As mentioned above, in a further embodiment, an additional (variable gain) amplifier is added at the output of the IQ mixer. This allows to optimize the linearity of the I/Q mixer 6, e.g. by not having the output of the I/Q mixer 6 go higher than the optimal linear range of the mixer (and using the additional amplifier to get a sufficiently high signal level. Also, it is then possible to keep the output of the I/Q mixer 6 at a sufficiently high level (not at levels comparable to DC signal noise levels (quantization noise), even if a lower level is desired at the bridge/coupler component 7 (then using an attenuation by the additional amplifier).

As shown in the system view of Fig. 4, the in-phase ($V_I$) and quadrature-phase ($V_Q$) signals of the control signal input 8 are sourced with accurate DC signals generated with high bit count digital to analogue converters (DACs) in DAC signal generator 12. The $V_I$ and $V_Q$ signals are used to steer the phase and control the amplitude of the injection signal (i.e., Cartesian modulation). The generated cancellation signal $b_{inj}$ is injected into path 1 of the divider coupler 4 in the same direction of the scattered wave b with a high directivity coupler 7 (of which the fourth port is coupled to a termination impedance 7a). The VNA 11 and the DAC signal generator 12 are placed inside a trigger/acknowledge loop using the indicated TTL and acknowledge (ACK) signal. During a frequency sweep the VNA 11 will change internal PLL sources to the next frequency in the sweep and send a TTL trigger to the signal generator 12 to set the proper values of the control signal input signals $V_I$ and $V_Q$ to generate the cancellation signal $b_{inj}$ for that specific frequency. The DAC signal generator 12 will send an ACK signal to initiate the VNA measurement. After this measurement, the VNA 11 will move to the next frequency and re-initiate the trigger/acknowledge protocol.

Therefore, the present invention in a further aspect relates to a system for executing measurements on a device under test (DUT) 9, comprising a vector network analyser 11, at least one DUT interface device 1 (HΓ-pod) according to any one of the present invention embodiments connected to an associated measuring port of the vector network analyser 11, and a control unit 12 connected to the vector network analyser 11 and to control input terminals 8 of associated ones of the at least one DUT interface device 1 (HΓ-pod). The control unit 12 is arranged to provide quadrature control signals $V_I$, $V_Q$ (i.e. synchronized I/Q mixer signals) for the associated at least one DUT interface device 1, wherein the at least one DUT interface device 1 is connected directly to the device under test 9. Thus, as compared to prior art systems, the loops in the measurement system are set-up differently, which improves performance. No longer is it necessary to provide a split of signals inside the vector network analyser 11. In the prior art solution the split is very far from the actual DUT loop creating several problems for the cancellation stability. Additionally, such an approach is making it very difficult to achieve two port configuration in conventional vector network analysers.

In a further embodiment, the control unit 12 comprises (high bit count) digital-to-analogue converters to provide quadrature control signals $V_1$, $V_Q$ for each of the at least one DUT interface device 1. The vector network analyser 11 is connected to the control unit 12 using a synchronization interface for executing frequency sweeps. E.g. the synchronization interface comprises a control signal (TTL) and an acknowledgment return signal (ACK), as discussed above.

According to a further aspect of the present invention, a method is provided for using a system according to any one of the embodiments described above, wherein the system comprises a DUT interface device 1 according to any one of the embodiments described herein connected to a first measuring port of the vector network analyser 11. The method comprises calibrating the system by obtaining injection signal parameters to allow measurements of a device under test 9 connected to the DUT interface device 1. Actual measurements of a device under test (DUT) 9 can then be executed by using the obtained injection signal parameters to control the DUT interface device 1 (i.e. with injection signal on).

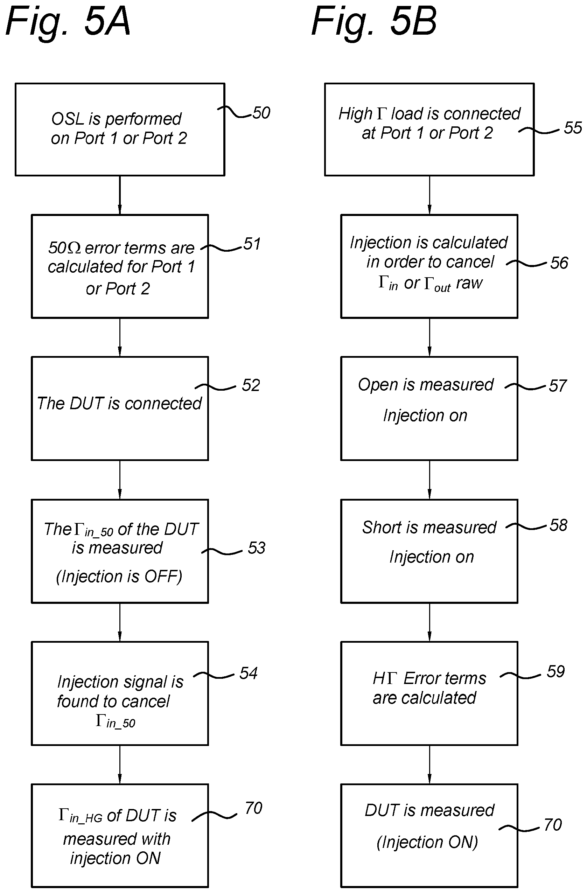

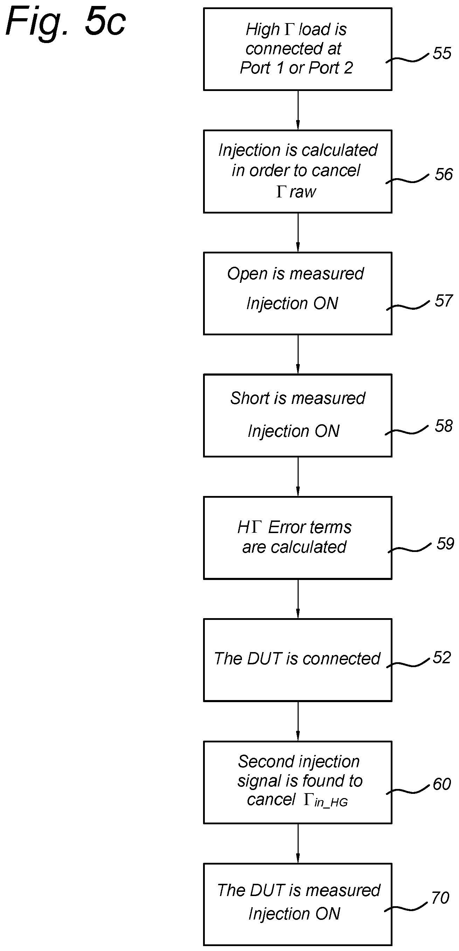

In accordance with further embodiments, one of three different calibration methods are provided to obtain various effects. In a first group of embodiments (labelled as method M1 in the following), measurement sensitivity at high gamma loads is improved (i.e. reduced trace noise), as shown in the flow schedule of Fig. 5A. In a second group of embodiments (labelled as method M2 in the following), absolute measurement accuracy at high gamma loads is improved by employing dedicated calibration structures, i.e., high gamma standards, as shown in the flow schedule of Fig. 5B. In a third group of embodiments (labelled as method M3 in the following), both absolute accuracy and sensitivity are improved by employing a combination of methods M1 and M2, as shown in the flow schedule of Fig. 5C.

The three groups of calibration procedures (methods M1, M2, M3) can be applied to a one port or a two port measurement system, following the description presented below.

Calibration method embodiments are provided for the test set-up arrangement of Fig. 4, for which the flow charts are shown in Fig. 5A, 5B and 5C. The setup calibration is based on a short-open-load (SOL) technique, to be applied to port one of a network analyser 11 only (one port DUT 9) or both port one and two of the network analyser 11 (two ports DUT 9). In order to extract consistent error terms to allow the measurement of full two-port error corrected scattering parameters (i.e., normalized to 50 $\Omega$) the injection signals are turned on and off at specific moments during the procedure as with reference to Fig. 5A, 5B and 5C.

Fig. 5A shows a flow chart for the first group of embodiments (method M1). This method comprises:

(block 50) perform a short-open-load calibration on the first measuring port of the vector network analyser 11 with the injection signal $b_{inj}$ off,
(block 51) calculating 50$\Omega$ error terms (i.e., system error terms $e_{00}$, $e_{11}$, $e_{10}e_{01}$),
(block 52) connecting the device under test 9,
(block 53) compute input reflection coefficient $\Gamma_{in\_50}$ of the device under test 9 in a 50 $\Omega$ environment.
(block 54) determine required quadrature control signals $V_I$, $V_Q$ to minimize the input reflection coefficient $\Gamma_{in\_50}$ (using e.g. an iteration algorithm).

Fig. 5B shows a flow chart for the second group of embodiments (method M2), This method comprises:

(block 55) connecting a high gamma load as device under test 9 to the first measuring port of the vector network analyser 11 via the first DUT interface device 1,
(block 56) determine required quadrature control signals $V_I$, $V_Q$ to minimize the reflection coefficients $\Gamma_{raw}$,
(block 57 and 58) perform a short-open calibration on the first measuring port of vector network analyser 11 with the injection signal $b_{inj}$ on, and
(block 59) compute system error terms ($e_{00\_HG}$, $e_{11\_HG}$, $e_{10}e_{01\_HG}$) in high gamma condition (i.e., injection signal on) for the first measuring port of the vector network analyser 11.

Both the method groups M1 and M2 may be applied for a two port DUT 9. To that end the system comprises a further DUT interface device connected to a second measuring port of the vector network analyser 11. The steps as described above are then repeated for the second measuring port of the vector network analyser (11).

Fig. 5C shows a flow chart for the third group of embodiments (method M3). This method comprises, in addition to the sequence of blocks 55-59 as described with reference to Fig. 5B: connecting the further DUT interface device 1 (block 52) and then determining the second injection signal (block 60).

As shown in the flow charts of Fig. 5A-5C, the calibration steps can then be followed by an actual measurement step 70 of the DUT 9, with the injection signal(s) $b_{inj}$ as determined in the calibration steps.

In more generic terms, a method embodiment is provided for calibrating a system according to any one of the system embodiments described herein, wherein the system comprises two DUT interface devices 1 connected to two measuring ports of the vector network analyser 11. The method comprises:

(a) connecting a high gamma load as device under test 9 to a first measuring port of the vector network analyser 11 via a first DUT interface device 1, (note that this is not used in method M1).
(b) determine required quadrature control signals $V_I$, $V_Q$ to minimize the reflection coefficients $\Gamma_{raw}$, (note that this is not used in method M1).
(c) perform a short-open-load calibration on the first measuring port of the vector network analyser 11 with the injection signal $b_{inj}$ off, (i.e. wherein the load is a standard system value, e.g. a 50$\Omega$ load).
(d) compute 50$\Omega$ system error terms $e_{00}$, $e_{11}$, $e_{10}e_{01}$ for the first measuring port of the vector network analyser 11,
(e) perform a short-open calibration on the first measuring port of vector network analyser 11 with the injection signal

$b_{inj}$ on (again, note that this is not used in method M1).

(f) compute HG system error terms $e_{00\_HG}$, $e_{11\_HG}$, $e_{10}e_{01\_HG}$ for the first measuring port of the vector network analyser 11, (note that this is not used in method M1),

repeating steps (a)-(e) for the second measuring port of the vector network analyser 11.

(g) in the case of method groups M1 and M3, the procedure is followed by determining at each frequency point the required $V_I$, $V_Q$ to minimize the reflection coefficients $\Gamma_{in}$/ $\Gamma_{out}$ of the DUT 9.

In a further embodiment, in step (b) the required quadrature signals $V_I$, $V_Q$ are determined for a range of frequencies of interest, i.e. a number of discrete frequencies in a frequency range. The method may further comprise computing two-port scattering parameters of the high gamma load as device under test 9 by using a thru connection between the first and second measuring port of the vector network analyser 11, with the injection signal ($b_{inj}$) off. These method embodiments are specifically advantageous in that both measurement ports are being calibrated, taking into account specific issues in relation to the use of two measurement ports of the vector network analyser11.

The above mentioned generic calibration method embodiments are clarified and further detailed in the following description.

The widely used short-open-load (SOL) method for calibration of one-port vector network analysers relies on three pre-characterized calibration devices used as device under test 9. The transfer function between uncorrected $\Gamma$raw and corrected $\Gamma$ reflection coefficient is determined through three error terms $e_{00}$, $e_{11}$, and $e_{10}e_{01}$, and $\Gamma$ at the calibration reference plane can be calculated using the following expression:

$$\Gamma = \frac{\Gamma_{raw} - e_{00}}{e_{10}e_{01} + e_{11} \cdot (\Gamma_{raw} - e_{00})} \qquad (1)$$

Here, the error terms $e_{00}$, $e_{11}$, and $e_{10}e_{01}$ respectively represent directivity, source match, and reflection tracking of the calibrated VNA 11. The SOL method relies on the use of three calibration devices with known electrical properties $\Gamma_i$, resulting in three independent measurements $\Gamma_{raw(i)}$ with three unknown error-terms, which are calculated using the following equation:

$$\begin{bmatrix} 1 & \Gamma_1 \cdot \Gamma_{raw1} & -\Gamma_1 \\ 1 & \Gamma_2 \cdot \Gamma_{raw2} & -\Gamma_2 \\ 1 & \Gamma_3 \cdot \Gamma_{raw3} & -\Gamma_3 \end{bmatrix} \cdot \begin{bmatrix} e_{00} \\ e_{11} \\ \Delta \end{bmatrix} = \begin{bmatrix} \Gamma_{raw1} \\ \Gamma_{raw2} \\ \Gamma_{raw3} \end{bmatrix} \quad (2)$$

$$\Delta = e_{00}e_{11} - e_{10}e_{01}$$

The calibration procedure is as follows (see also flow charts of Fig. 5B and 5C):

The impedance standard of interest HighGamma$_{load}$ (H$\Gamma$) is connected to the system test-port (block 55). The measurement software uses an iteration algorithm (e.g. the Newton-Raphson algorithm. as such known to the person skilled in the art) to minimize $\Gamma_{raw}$ to zero (e.g. at every desired frequency, block 56) and stores the corresponding $V_I(f)$ and $V_Q(f)$ values (this step does not apply to calibration method M1, see Fig. 5A).

A first SOL calibration with injection signal $b_{inj}$ turned off is performed (applies to all method groups M1-M2-M3).

A conventional SOL calibration method is used (block 59) for calculation of system error terms, see equation (2), with injection off ($e_{term\_50}$).

The second SOL calibration is performed with the measurement of three calibration devices with suitable electrical properties to improve accuracy over the impedance measurement range of interest, the H$\Gamma$, and two other known device typically the short (S) and the open (O). This applies to method groups M2 and M3 only. Again, a conventional SOL calibration method is used for calculation of system error terms, see equation (2), with injection on ($e_{term\_HG}$).

The standard definition of the short and the open is converted in the gamma plane of the new reference impedance, i.e., where HighGamma$_{load}$ (H$\Gamma$) is now zero. Considering $Z_1$ the original reference impedance and $Z_2$ the new reference impedance, the scattering matrix $S_i$ associated to either the short or the open standard in $Z_1$ is converted in the new reference plane using the equation:

$$S' = P^{-1}(S - \gamma)(I - \gamma S)^{-1}P$$

wherein:

$$P = \sqrt{\frac{Re(Z_1)}{Re(Z_2)}} \left|\frac{Z_1}{Z_2}\right| \frac{2Z_1}{Z_1 + Z_2}$$

$$\gamma = \frac{Z_2 - Z_1}{Z_2 + Z_1}$$

and S is the scattering matrix in the old reference system and S' is the new reference system (i.e., high gamma), I is the identity matrix.

- The same procedure is then repeated for port two.

With the system error-terms known, equation (1) is used to correct the input and output reflection coefficient of the high gamma device with injection on.

In order to compute the two-ports scattering parameters of the extreme gamma device the load match ($e_{22}$) and transmission tracking term ($e_{10}e_{32}$) are then computed.

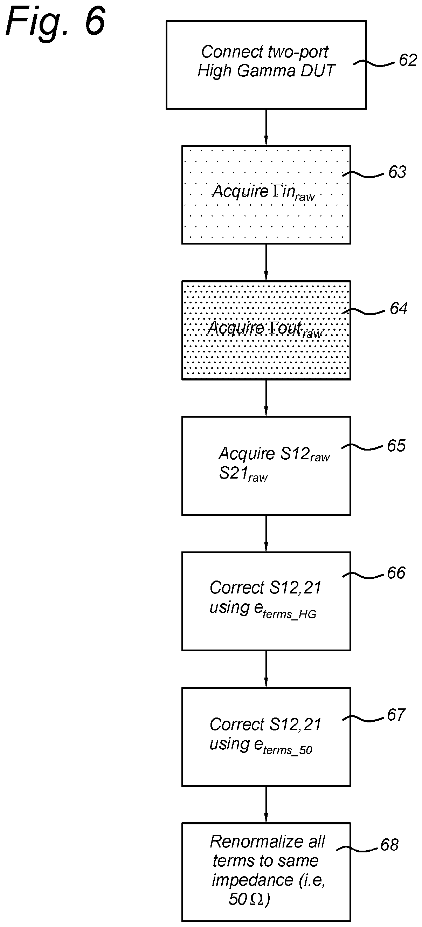

In order to obtain improved two port parameters of a high $\Gamma$ device (i.e., reduced mismatched uncertainty and increased absolute accuracy of the reflection coefficients, using method group M3), after the above described calibration the measurement procedure is as follows, see Fig. 6 for the flow graph representation:

0) Connect the two-port high $\Gamma$ DUT 9 (step 62)
1) Turn on the cancellation signal at port one, and acquire the raw input reflection coefficient $\Gamma_{INraw}$ (step 63, sparse dot pattern)
2) Turn on the cancellation signal at port two, and acquire the raw output reflection coefficient $\Gamma_{OUTraw}$ (step 64, dense dot pattern)
3) Turn the injection signals off and acquire $S12_{raw}$ and $S21_{raw}$ (step 65)
4) Correct the input/output reflection coefficients ($\Gamma_{IN}$ and $\Gamma_{OUT}$) using eq. (1) and $e_{term\_HG}$ (step 66)
5) Correct the S21 and S12 using two port calibration equation (see above) and $e_{term\_50}$ (step 67)
5) Use the following eq. (4) to obtain the normalized scattering parameters of the high $\Gamma$ DUT 9 (step 68)

$$s_{11} = \frac{1}{2} \frac{1}{e_{22R}(e_{22F}\Gamma_{OUT} - 1)} (e_{22F}e_{22R}\Gamma_{IN}\Gamma_{OUT} + \Gamma_{OUT}e_{22F} - e_{22R}\Gamma_{IN} - 1 +$$

$$+ \sqrt{(e_{22R}\Gamma_{IN} - 1)(e_{22F}\Gamma_{OUT} - 1)(e_{22F}e_{22R}\Gamma_{IN}\Gamma_{OUT} + 4e_{22F}e_{22R}S_{12}S_{21} - \Gamma_{OUT}e_{22F} - e_{22R}\Gamma_{IN} + 1))}$$

$$s_{22} = \Gamma_{OUT} - \frac{s_{12}s_{21}e_{22R}}{1 - s_{11}e_{22R}}$$

(4)

Where the error terms in (4) are $e_{term-50}$.

If the method M1 is applied for a two port DUT 9 measurement (using a further DUT interface device 1) the following method steps may also describe this method M1:

connecting a high gamma load as device under test 9 to the two measuring ports of the vector network analyser 11 via associated DUT interface devices 1, (block 62);
acquiring corrected two port S-parameters of the DUT with injection off, and using 50 $\Omega$ error terms, derive the $V_1$ and $V_Q$ signals to cancel the corrected input and output reflection coefficient, i.e., identify the cancellation signal $b_{inj}$. Furthermore, renormalizing the S-parameter to a given reference impedance may be performed (block 68).

Also method M2 may be applied for a two-port DUT 9, with the following modifications to the method M2 (with reference to the blocks identified in Fig. 6):

acquiring corrected $\Gamma_{IN}$ and $\Gamma_{OUT}$ parameters of the DUT with injection on, and using the High Gamma error terms (block 63, 64),
acquiring scattering parameters $S12_{raw}$, $S21_{raw}$ with injection signals $b_{inj}$ to both measuring ports off (block 65),
correcting the acquired parameters using the system error terms obtained from the method for calibration (block 66, 67),
obtaining normalized scattering parameters for the high gamma load as device under test 9 (block 68).

The method group M3 can in this respect be seen as a repeat of the procedure of method group M2 and then derive the $V_I$ and $V_Q$ signals to cancel the corrected input and output reflection coefficient, i.e., identify the cancellation signal $b_{inj}$, followed by renormalizing the S-parameter to a given reference impedance.

When considering a frequency sweep of the DUT 9, due to the reactive parasitic and delays involved, the measured impedance (at any port) will vary versus frequency, in many cases going from a high gamma value at lower frequencies to a lower gamma value at higher frequencies.

In a further embodiment of the present invention, a decision making algorithm is added to the method embodiments, based on the system sensitivity. The decision making algorithm was developed to choose, during the post processing phase of the measurement, which data will provide a lower uncertainty.

The algorithm is based on computing the derivative of the magnitude of the reflection coefficient (normalized to $50\Omega$) in respect of the magnitude of Z, this quantity will be defined as $\Delta$. The system settings (injection off versus injection on) providing the highest value of $\Delta$ for any given impedance will provide the highest sensitivity and thus lowest uncertainty, and will be used to further process the data. Thus, in a further embodiment of the measurement method the measurement of a device under test (DUT) is executed at a predetermined frequency with or without injection signals $b_{inj}$ in dependence of a sensitivity parameter $\Delta$, the sensitivity parameter $\Delta$ being defined as the derivative of the magnitude of the reflection coefficient $\Gamma$ in respect of the magnitude of the load impedance Z.

In an example $\Delta$ is computed for a (standard) $50\Omega$ system and the system with injection on (i.e., $1K\Omega$ in the specific case). Depending on the value of $\Delta$ the data from the $50\Omega$ system may provide a higher sensitivity, or the data from the $1K\Omega$ system will provide a higher sensitivity, and a selection is made accordingly.

It is noted that the present invention embodiments are advantageously applicable when the high gamma load, in operation, has a high voltage standing wave ratio (as compared to normal system impedance of $50\Omega$), e.g. a voltage standing wave ratio is higher than 9.

The present invention has been described above with reference to a number of exemplary embodiments as shown in the drawings. Modifications and alternative implementations of some parts or elements are possible, and are included in the scope of protection as defined in the appended claims.

**Claims**

1. Device under test (DUT) interface device for connecting a vector network analyser (11) to a device under test (9), comprising
   an analyser terminal (2), a DUT terminal (3), and a control input terminal (8),
   a divider/coupler component (4) having a main terminal connected to the analyser terminal (2),
   a variable gain amplifier (5) connected to a first branch terminal of the divider/coupler component (4),
   an I/Q mixer (6) having an input terminal connected to an output terminal of the variable gain amplifier (5),
   a bridge/coupler component (7), of which first branch terminals are connected between a second branch terminal of the divider/coupler component (4) and the DUT terminal (3) for providing a test signal (a) to the DUT terminal (3), and second branch terminals are connected between an output of the I/Q mixer (6) and a grounding impedance (7a).

2. DUT interface device according to claim 1, wherein the divider/coupler component (4) is a high directivity power divider/coupler splitting a test signal on the main terminal over the first and second branch terminals.

3. DUT interface device according to claim 1 or 2, wherein the I/Q mixer (6) is arranged to generate an injection signal ($b_{inj}$) which is coherently combined with a reflected signal (b) received on the DUT terminal (3).

4. DUT interface device according to claim 1, 2 or 3, wherein the I/Q mixer (6) is connected to the control input terminal (8).

5. DUT interface device according to any one of claims 1-4, wherein the variable gain amplifier (5) comprises a plurality of variable attenuators.

6. System for executing measurements on a device under test (DUT, 9) comprising a vector network analyser (11), at least one DUT interface device (1) according to any one of claims 1-5 connected to an associated measuring port of the vector network analyser (11), and
a control unit (12) connected to the vector network analyser (11) and to control input terminals (8) of associated ones of the at least one DUT interface device (1), wherein the control unit (12) is arranged to provide quadrature control signals ($V_I$, $V_Q$) for the associated at least one DUT interface device (1),
wherein the at least one DUT interface device (1) is connected directly to the device under test (DUT, 9).

7. System according to claim 6, wherein the control unit (12) comprises digital-to-analogue converters to provide quadrature control signals ($V_I$, $V_Q$) for each of the at least one DUT interface device (1).

8. System according to claim 7, wherein the vector network analyser (11) is connected to the control unit (12) using a synchronization interface for executing frequency sweeps.

9. System according to claim 8, wherein the synchronization interface comprises a control signal (TTL) and an acknowledgment return signal (ACK).

10. Method for using a system according to any one of claims 6-9, wherein the system comprises a DUT interface device (1) according to any one of claims 1-5 connected to a first measuring port of the vector network analyser (11), comprising
calibrating the system by obtaining injection signal parameters to allow measurements of a device under test (9) connected to the DUT interface device (1).

11. Method according to claim 10, further comprising

(a) perform a short-open-load calibration on the first measuring port of the vector network analyser (11) with the injection signal ($b_{inj}$) off,
(b) calculating 50$\Omega$ error terms,
(c) connecting the device under test (9),
(d) compute input reflection coefficient $\Gamma_{in\_50}$ of the device under test (9) in a 50 $\Omega$ environment and determine required quadrature control signals ($V_I$, $V_Q$) to minimize the input reflection coefficient $\Gamma_{in\_50}$.

12. Method according to claim 10, further comprising

(a) connecting a high gamma load as device under test (9) to the first measuring port of the vector network analyser (11) via the first DUT interface device (1),
(b) determine required quadrature control signals ($V_I$, $V_Q$) to minimize the reflection coefficients ($\Gamma_{aw}$),
(c) perform a short-open calibration on the first measuring port of vector network analyser (11) with the injection signal ($b_{inj}$) on, and
(d) compute system error terms ($e_{00\_HG}$, $e_{11\_HG}$, $e_{10}e_{01\_HG}$) for the first measuring port of the vector network analyser (11).

13. Method according to claim 11 or 12, wherein the system comprises a further DUT interface device (1) according to any one of claims 1-5, wherein the further DUT interface device (1) is connected to a second measuring port of the vector network analyser (11), the method further comprising
repeating steps (a)-(d) for the second measuring port of the vector network analyser (11).

14. Method according to claim 10, further comprising,
connecting a high gamma load as device under test (9) to the first and second measuring port of the vector network analyser (11) via the associated DUT interface devices (1),
acquiring raw input reflection coefficients ($\Gamma_{INraw}$) on the first measuring port of the vector network analyser (11) using the associated injection signal ($b_{inj}$),
acquiring raw output reflection coefficients ($\Gamma_{OUTraw}$) on the second measuring port of the vector network analyser (11) using the associated injection signal ($b_{inj}$),
acquiring scattering parameters ($S12_{raw}$, $S21_{raw}$) with injection signals ($b_{inj}$) to both measuring ports off,
correcting the acquired parameters using the system error terms obtained from the calibration method step,
obtaining normalized scattering parameters for the high gamma load as device under test (9).

**15.** Method according to any one of claims 10-14, wherein measurement of a device under test (DUT) is executed at a predetermined frequency with or without injection signals ($b_{inj}$) in dependence of a sensitivity parameter ($\Delta$), the sensitivity parameter ($\Delta$) being defined as the derivative of the magnitude of the reflection coefficient ($\Gamma$) in respect of the magnitude of the load impedance (Z).

**Patentansprüche**

**1.** Vorrichtung mit Device Under Test (DUT)-Schnittstelle zur Verbindung eines Vektornetzwerkanalysierers (11) mit einem zu prüfenden Gerät (9), umfassend
einen Analysieranschluss (2), einen DUT-Anschluss (3) und einen Steuereingabeanschluss (8),
eine Teiler/Koppler-Komponente (4), die einen Hauptanschluss aufweist, der mit dem Analysieranschluss (2) verbunden ist,
einen Verstärker mit variabler Verstärkung (5), der mit einem ersten Abzweiganschluss der Teiler/Koppler-Komponente (4) verbunden ist,
einen I/Q-Mixer (6), der einen Eingabeanschluss aufweist, der mit einem Ausgabeanschluss des Verstärker mit variabler Verstärkung (5) verbunden ist,
eine Brückenkopplerkomponente (7), deren erste Abwzeiganschlüsse zwischen einem zweiten Abwzeiganschluss der Teiler/Koppler-Komponente (4) und dem DUT-Anschluss (3) verbunden sind, um ein Testsignal (a) an den DUT-Anschluss (3) zu liefern, und deren zweite Abzweiganschlüsse zwischen einem Ausgang des I/Q-Mixers (6) und einer Erdimpedanz (7a) verbunden sind.

**2.** Vorrichtung mit DUT-Schnittstelle nach Anspruch 1, wobei die Teiler/Koppler-Komponente (4) ein Hochausrichtungsleistungsteiler/Koppler ist, der ein Testsignal auf dem Hauptanschluss über die ersten und zweiten Abzweiganschlüsse teilt.

**3.** Vorrichtung mit DUT-Schnittstelle nach Anspruch 1 oder 2, wobei der I/Q-Mixer (6) eingerichtet ist, ein Injektionssignal ($b_{inj}$) zu erzeugen, dass kohärent mit einem reflektierten Signal (b) kombiniert wird, das an dem DUT-Anschluss (3) empfangen wird.

**4.** Vorrichtung mit DUT-Schnittstelle nach Anspruch 1, 2 oder 3, wobei der I/Q-Mixer (6) mit dem Steuereingabeanschluss (8) verbunden ist.

**5.** Vorrichtung mit DUT-Schnittstelle nach einem der Ansprüche 1 bis 4, wobei der Verstärker mit variabler Verstärkung (5) eine Vielzahl variabler Dämpfungsglieder umfasst.

**6.** System zum Ausführen von Messungen an einem zu prüfenden Gerät (DUT, 9), umfassend einen Vektornetzwerkanalysierer (11), wenigstens eine Vorrichtung mit DUT-Schnittstelle (1) nach einem der Ansprüche 1 bis 5, das mit einem zugeordneten Messanschluss des Vektornetzwerkanalysierers (11) verbunden ist, und
eine Steuereinheit (12), die mit dem Vektornetzwerkanalysierers (11) verbunden ist und zum Steuern von Eingabeanschlüssen (8) zugeordneter Vorrichtungen der wenigstens einen Vorrichtung mit DUT-Schnittstelle (1) eingerichtet ist, wobei die Steuereinheit (12) eingerichtet ist, Quadratursteuersignale ($V_I$, $V_Q$) für die zugeordnete wenigstens eine Vorrichtung mit DUT-Schnittstelle (1) zu liefern,
wobei die wenigstens eine Vorrichtung mit DUT-Schnittstelle (1) direkt mit dem zu prüfenden Gerät (DUT, 9) verbunden ist.

**7.** System nach Anspruch 6, wobei die Steuereinheit (12) Digital-Analog-Umsetzer umfasst, die eingerichtet sind, Quadratursteuersignale ($V_I$, $V_Q$) für jeden der wenigstens einen Vorrichtung mit DUT-Schnittstelle (1) zu liefern.

**8.** System nach Anspruch 7, wobei der Vektornetzwerkanalysierer (11) mit der Steuereinheit (12) mittels einer Synchronisationsschnittstelle zum Ausführen von Frequenzdurchläufen verbunden ist.

**9.** System nach Anspruch 8, wobei die Synchronisationsschnittstelle ein Steuersignal (TTL) und ein Rückbestätigungssignal (ACK) umfasst.

**10.** Verfahren zur Verwendung eines Systems nach einem der Ansprüche 6 bis 9, wobei das System eine Vorrichtung mit DUT-Schnittstelle (1) nach einem der Ansprüche 1 bis 5 umfasst, das mit einem ersten Messanschluß des Vektornetzwerkanalysierers (11) verbunden ist, umfassend

Kalibrieren des Systems durch Einholen von Injektionssignalparametern, um Messungen des zu prüfenden Geräts (9) zu ermöglichen, das mit der DUT-Schnittstellenvorrichtung (1) verbunden ist.

**11.** Verfahren nach Anspruch 10, ferner umfassend

(a) Durchführen einer Short-Open-Load-Kalibrierung an dem ersten Messanschluss des Vektornetzwerkanalysierers (11) bei ausgeschaltetem Injektionssignal ($b_{inj}$),
(b) Berechnen von 50 $\Omega$ Fehlerausdrücken,
(c) Verbinden des zu prüfenden Geräts (9),
(d) Berechnen von Eingabereflektionskoeffizient $\gamma_{in50}$ des zu prüfenden Geräts (9) in einer 50 $\Omega$-Umgebung, und Bestimmen erforderlicher Quadratursteuersignale ($V_I$, $V_Q$), um den Eingabereflektionskoeffizienten $\gamma_{in50}$ zu minimieren.

**12.** Verfahren nach Anspruch 10, ferner umfassend

(a) Verbinden einer Last mit hohem Gamma als zu prüfendem Gerät (9) mit dem ersten Messanschluss des Vektornetzwerkanalysierers (11) über die erste DUT-Schnittstellenvorrichtung (1),
(b) Bestimmen erforderlicher Quadratursteuersignale ($V_I$, $V_Q$) zum Minimeren der Reflektionskoeffizienten ($\gamma_{raw}$),
(c) Durchführen einer Shot-Open-Kalibrierung an dem ersten Messanschluss des Vektornetzwerkanalysierers (11) bei eingeschaltetem Injektionssignal ($b_{inj}$), und
(d) Berechnen von Systemfehlerausdrücken ($e_{00}HG$, $e_{11}HG$, $e_{10}$ $e_{01}HG$) für den ersten Messanschluss des Vektornetzwerkanalysierers (11).

**13.** Verfahren nach Anspruch 11 oder 12, wobei das System eine weitere DUT-Schnittstellenvorrichtung (1) nach einem der Ansprüche 1 bis 5 umfasst, wobei die weitere DUT-Schnittstellenvorrichtung (1) mit einem zweiten Messanschluss des Vektornetzwerkanalysierers (11) verbunden ist, wobei das Verfahren ferner umfasst Wiederholen der Schritte (a) bis (d) für den zweiten Messanschluss des Vektornetzwerkanalysierers (11).

**14.** Verfahren nach Anspruch 10, ferner umfassend,
Verbinden einer Last mit hohem Gamma als zu prüfendem Gerät (9) mit dem ersten und zweiten Messanschluss des Vektornetzwerkanalysierers (11) über die zugeordneten DUT-Schnittstellenvorrichtungen (1),
Einholen roher Eingabereflektionskoeffizienten ($\gamma INraw$) an dem ersten Messanschluss des Vektornetzwerkanalysierers (11) unter Verwendung des zugeordneten Injektionssignals ($b_{inj}$),
Einholen roher Ausgabereflektionskoeffizienten ($\gamma_{OUT-raw}$) an dem zweiten Messanschluss des Vektornetzwerkanalysierers (11) unter Verwendung des zugeordneten Injektionssignals ($b_{inj}$),
Einholen von Streuparametern ($S12_{raw}$, $S21_{raw}$) mit Injektionssignalen ($b_{inj}$) bei ausgeschalteten beiden Messanschlüssen,
Korrigieren der eingeholten Parameter unter Verwendung der Systemfehlerausdrücke, die in dem Kalibrierungsverfahrensschritt eingeholt wurden,
Einholen normalisierter Streuparameter für die Last mit hohem $\gamma$ als zu prüfendem Gerät (9).

**15.** Verfahren nach einem der Ansprüche 10 bis 14, wobei eine Messung eines zu prüfenden Geräts (DUT) bei einer vorbestimmten Frequenz mit oder ohne Injektionssignalen ($b_{inj}$) abhängig von einem Empfindlichkeitsparameter ($\Delta$) ausgeführt wird, wobei der Empfindlichkeitsparameter ($\Delta$) als Ableitung der Magnitude des Reflektionskoeffizienten ($\Gamma$) bezüglich der Magnitude der Lastimpedanz (Z) ist.

## Revendications

**1.** Dispositif d'interface de dispositif à l'essai (DUT) pour connecter un analyseur de réseau vectoriel (11) à un dispositif à l'essai (9), comprenant
une borne d'analyseur (2), une borne de DUT (3) et une borne d'entrée de commande (8),
un composant diviseur/coupleur (4) ayant une borne principale connectée à la borne d'analyseur (2),
un amplificateur à gain variable (5) connecté à une première borne de dérivation du composant diviseur/coupleur (4),
un mélangeur I/Q (6) ayant une borne d'entrée connectée à une borne de sortie de l'amplificateur à gain variable (5),
un composant pont/coupleur (7), dont des premières bornes de dérivation sont connectées entre une seconde borne de dérivation du composant diviseur/coupleur (4) et la borne de DUT (3) pour fournir un signal d'essai (a) à la borne de DUT (3), et des secondes bornes de dérivation sont connectées entre une sortie du mélangeur I/Q (6) et une impédance de mise à la terre (7a).

2. Dispositif d'interface de DUT selon la revendication 1, dans lequel le composant diviseur/coupleur (4) est un diviseur/coupleur de puissance à haute directivité divisant un signal d'essai sur la borne principale sur les première et seconde bornes de dérivation.

3. Dispositif d'interface de DUT selon la revendication 1 ou 2, dans lequel le mélangeur I/Q (6) est agencé pour générer un signal d'injection ($b_{inj}$) qui est combiné de manière cohérente avec un signal réfléchi ($b$) reçu sur la borne de DUT (3).

4. Dispositif d'interface de DUT selon la revendication 1, 2 ou 3, dans lequel le mélangeur I/Q (6) est connecté à la borne d'entrée de commande (8).

5. Dispositif d'interface de DUT selon l'une quelconque des revendications 1 à 4, dans lequel l'amplificateur à gain variable (5) comprend une pluralité d'atténuateurs variables.

6. Système pour exécuter des mesures sur un dispositif à l'essai (DUT, 9) comprenant un analyseur de réseau vectoriel (11), au moins un dispositif d'interface de DUT (1) selon l'une quelconque des revendications 1 à 5 connecté à un port de mesure associé de l'analyseur de réseau vectoriel (11), et
une unité de commande (12) connectée à l'analyseur de réseau vectoriel (11) et pour commander des bornes d'entrée (8) de certains associés du au moins un dispositif d'interface de DUT (1), dans lequel l'unité de commande (12) est agencée pour fournir des signaux de commande en quadrature ($V_I$, $V_Q$) pour le au moins un dispositif d'interface de DUT associé (1),
dans lequel le au moins un dispositif d'interface de DUT (1) est connecté directement au dispositif à l'essai (DUT, 9).

7. Système selon la revendication 6, dans lequel l'unité de commande (12) comprend des convertisseurs numérique-analogique pour fournir des signaux de commande en quadrature ($V_I$, $V_Q$) pour chaque au moins un dispositif d'interface de DUT (1).

8. Système selon la revendication 7, dans lequel l'analyseur de réseau vectoriel (11) est connecté à l'unité de commande (12) en utilisant une interface de synchronisation pour exécuter des balayages de fréquence.

9. Système selon la revendication 8, dans lequel l'interface de synchronisation comprend un signal de commande (TTL) et un signal de retour d'accusé de réception (ACK).

10. Procédé d'utilisation d'un système selon l'une quelconque des revendications 6 à 9, dans lequel le système comprend un dispositif d'interface de DUT (1) selon l'une quelconque des revendications 1 à 5 connecté à un premier port de mesure de l'analyseur de réseau vectoriel (11), comprenant les étapes consistant à
calibrer le système en obtenant des paramètres de signal d'injection pour permettre des mesures d'un dispositif à l'essai (9) connecté au dispositif d'interface de DUT (1).

11. Procédé selon la revendication 10, comprenant en outre les étapes consistant à

(a) effectuer un calibrage à charge ouverte courte sur le premier port de mesure de l'analyseur de réseau vectoriel (11) avec le signal d'injection ($b_{inj}$) éteint,
(b) calculer des termes d'erreur de 50 $\Omega$,
(c) connecter le dispositif à l'essai (9),
(d) calculer le coefficient de réflexion d'entrée $\Gamma_{in\_50}$ du dispositif à l'essai (9) dans un environnement de 50 $\Omega$ et déterminer des signaux de commande en quadrature requis ($V_I$, $V_Q$) pour minimiser le coefficient de réflexion d'entrée $\Gamma_{in\_50}$.

12. Procédé selon la revendication 10, comprenant en outre les étapes consistant à

(a) connecter une charge gamma élevée en tant que dispositif à l'essai (9) au premier port de mesure de l'analyseur de réseau vectoriel (11) via le premier dispositif d'interface de DUT (1),
(b) déterminer des signaux de commande en quadrature requis ($V_I$, $V_Q$) pour minimiser les coefficients de réflexion ($\Gamma_{raw}$),
(c) effectuer un calibrage à charge ouverte courte sur le premier port de mesure de l'analyseur de réseau vectoriel (11) avec le signal d'injection ($b_{inj}$) allumé, et

(d) calculer des termes d'erreur du système ($e_{00\_HG}$, $e_{11\_HG}$, $e_{10}e_{01\_HG}$) pour le premier port de mesure de l'analyseur de réseau vectoriel (11).

**13.** Procédé selon la revendication 11 ou 12, dans lequel le système comprend un dispositif d'interface de DUT supplémentaire (1) selon l'une quelconque des revendications 1 à 5, dans lequel le dispositif d'interface de DUT supplémentaire (1) est connecté à un second port de mesure de l'analyseur de réseau vectoriel (11), le procédé comprenant en outre l'étape consistant à :

répéter les étapes (a) à (d) pour le second port de mesure de l'analyseur de réseau vectoriel (11).

**14.** Procédé selon la revendication 10, comprenant en outre les étapes consistant à

connecter une charge gamma élevée en tant que dispositif à l'essai (9) au premier et au second port de mesure de l'analyseur de réseau vectoriel (11) via les dispositifs d'interface de DUT associés (1),

acquérir des coefficients de réflexion d'entrée bruts ($\Gamma_{INraw}$) sur le premier port de mesure de l'analyseur de réseau vectoriel (11) en utilisant le signal d'injection associé ($b_{inj}$),

acquérir des coefficients de réflexion de sortie bruts ($\Gamma_{OUTraw}$) sur le second port de mesure de l'analyseur de réseau vectoriel (11) en utilisant le signal d'injection associé ($b_{inj}$),

acquérir des paramètres de diffusion ($S12_{raw}$, $S21_{raw}$) avec des signaux d'injection ($b_{inj}$) aux deux ports de mesure éteints,

corriger les paramètres acquis à l'aide des termes d'erreur de système obtenus à l'étape de procédé de calibrage, obtenir des paramètres de diffusion normalisés pour la charge gamma élevée en tant que dispositif à l'essai (9).

**15.** Procédé selon l'une quelconque des revendications 10 à 14, dans lequel une mesure d'un dispositif à l'essai (DUT) est exécutée à une fréquence prédéterminée avec ou sans signaux d'injection ($b_{inj}$) en fonction d'un paramètre de sensibilité ($\Delta$), le paramètre de sensibilité ($\Delta$) étant défini comme la dérivée de l'amplitude du coefficient de réflexion ($\Gamma$) par rapport à l'amplitude de l'impédance de charge (Z).

*Fig. 1*

*Fig. 2*

## Fig. 3

## Fig. 4

# Fig. 5A

OSL is performed
on Port 1 or Port 2 — 50

↓

$50\,\Omega$ error terms are
calculated for Port 1
or Port 2 — 51

↓

The DUT is connected — 52

↓

The $\Gamma_{in\_50}$ of the DUT
is measured
(Injection is OFF) — 53

↓

Injection signal is
found to cancel
$\Gamma_{in\_50}$ — 54

↓

$\Gamma_{in\_HG}$ of DUT is
measured with
injection ON — 70

# Fig. 5B

High $\Gamma$ load is connected
at Port 1 or Port 2 — 55

↓

Injection is calculated
in order to cancel
$\Gamma_{in}$ or $\Gamma_{out}$ raw — 56

↓

Open is measured
Injection on — 57

↓

Short is measured
Injection on — 58

↓

$H\Gamma$ Error terms
are calculated — 59

↓

DUT is measured
(Injection ON) — 70

*Fig. 5c*

High Γ load is
connected at
Port 1 or Port 2 — 55

↓

Injection is calculated
in order to cancel
Γ raw — 56

↓

Open is measured
Injection ON — 57

↓

Short is measured
Injection ON — 58

↓

HΓ Error terms
are calculated — 59

↓

The DUT is connected — 52

↓

Second injection
signal is found to
cancel Γ$_{in\_HG}$ — 60

↓

The DUT is measured
Injection ON — 70

# Fig. 6

```
Connect two-port
High Gamma DUT            62

         ↓

Acquire Γin_raw            63

         ↓

Acquire Γout_raw           64

         ↓

Acquire S12_raw
S21_raw                    65

         ↓

Correct S12,21
using e_terms_HG           66

         ↓

Correct S12,21
using e_terms_50           67

         ↓

Renormalize all
terms to same
impedance (i.e,
50 Ω)                      68
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. VLACHOGIANNAKIS et al.** An I/Q-Mixer-Steering Interferometric Technique for High-Sensitivity Measurement of Extreme Impedances. *International Microwave Symposium,* May 2015
- Evaluation and modeling of measurement resolution of a vector network analyzer for extreme impedance measurements. **M. FAISAL.** 2015 86th ARFTG Microwave Measurement Conference. IEEE, 03 December 2015
- Interferometric technique for microwave measurement of high impedances. **K. HADDADI.** Microwave Symposium Digest, 2012 IEEE MTT-S International. IEEE, 17 June 2012
- **G. VLACHOGIANNAKIS ; H.T. SHIVAMURTHY et al.** An I/Q-Mixer-Steering Interferometric Technique for High-Sensitivity Measurement of Extreme Impedances. *International Microwave Symposium,* May 2015